(19) Europäisches Patentamt
European Patent Office
Office européen des brevets

(11) EP 2 740 167 B1

(12) **EUROPEAN PATENT SPECIFICATION**

(45) Date of publication and mention of the grant of the patent:
**26.12.2018 Bulletin 2018/52**

(21) Application number: **11741448.2**

(22) Date of filing: **03.08.2011**

(51) Int Cl.:
***H01L 51/00*** *(2006.01)* *H01L 51/05* *(2006.01)*

(86) International application number:
**PCT/EP2011/063372**

(87) International publication number:
**WO 2013/017170 (07.02.2013 Gazette 2013/06)**

# (54) METHOD OF MANUFACTURING LOW VOLTAGE ORGANIC TRANSISTOR

HERSTELLUNGSMETHODE EINES ORGANISCHEN NIEDERSPANNUNGSTRANSISTORS

MÉTHODE DE PRÉPARATION D'UN TRANSISTOR ORGANIQUE À BASSE TENSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**11.06.2014 Bulletin 2014/24**

(73) Proprietor: **UNIVERSITA' DEGLI STUDI DI CAGLIARI**
**09124 Cagliari (IT)**

(72) Inventors:
- **COSSEDDU, Piero**
  **09125 Cagliari (IT)**
- **LAI, Stefano**
  **09134 Cagliari (IT)**
- **BARBARO, Massimo**
  **09126 Cagliari (IT)**
- **BONFIGLIO, Annalisa**
  **09131 Cagliari (IT)**

(74) Representative: **Porta, Checcacci & Associati S.p.A**
**Via Vittoria Colonna, 4**
**20149 Milano (IT)**

(56) References cited:
**US-A1- 2004 251 474**

- **WOO CHEOL SHIN ET AL: "Low-Voltage High-Performance Pentacene Thin-Film Transistors With Ultrathin PVP/High- \kappa HfLaO Hybrid Gate Dielectric", IEEE ELECTRON DEVICE LETTERS, IEEE SERVICE CENTER, NEW YORK, NY, US, vol. 21, no. 11, 1 November 2010 (2010-11-01), pages 1308-1310, XP011317786, ISSN: 0741-3106 cited in the application**
- **NEWMAN CHRISTOPHER ET AL: "High mobility top-gated pentacene thin-film transistors", JOURNAL OF APPLIED PHYSICS, AMERICAN INSTITUTE OF PHYSICS, US, vol. 98, no. 8, 20 October 2005 (2005-10-20), pages 84506-084506, XP012078845, ISSN: 0021-8979, DOI: 10.1063/1.2076429**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

Technical field

The present invention relates to an organic transistor having low operating voltages. The transistor includes a double layer of dielectric materials.

Technological background

Organic Electronics is experiencing a large effort of research for the many advantages and potential disruptive applications that could offer. Organic Field-Effect transistors (OFETs) also sometimes known as Organic Thin Film Transistors (OTFTs) are attracting widespread interest today because of the possibility to fabricate these with acceptable performances over large areas and on flexible substrates using cost-effective and materials-efficient fabrication methods. However, there are still some technical problems that, as a matter of fact, put a serious concern to these possibilities. One of them is the fact that, due to the low mobility of organic semiconductors, it is normally necessary to operate devices, in particular, field effect transistors, with very high - up to 100 V - voltages, both for drain-source and for gate-source potentials. Unfortunately, despite the extraordinary progresses exhibited by active semiconductor materials in terms of mobility and stability, this very high voltages normally needed for biasing OTFTs pose a serious concern for many applications as, for instance, electronic circuits and sensors. In fact, it is virtually impossible to battery-operate OTFT-based devices without a suitable electronic (non organic) interface for step-up conversion of the battery supply voltage.

Field-effect transistors are three-terminal devices comprising gate (G), source (S) and drain (D) electrodes. In an OFET, an organic semiconductor is deposited to bridge the source and drain electrodes, and is itself spaced from the gate electrode by an insulating gate dielectric layer. The organic semiconductor can be a pi-conjugated polymer or oligomer. A voltage $V_{gs}$ is applied to the gate to control the amount of charge accumulation at the interface between the semiconductor and the insulating layer; a voltage $V_{ds}$ is applied to the drain to induce the current flow between the source and drain.

OFET research generally seeks to optimize two important values, the carrier mobility and the on/off current ratio. Semiconductor conductivity is directly proportional to carrier mobility, and this is thus directly related to the performance of the device.

The relationship between the drain current and the various characteristics and applied voltages of the OFET is interpreted through conventional semiconductor theory, which reproduces the general trends in OFET characteristics

$$I_D = \frac{W}{L}\mu_p C_i\left[(V_{GS} - V_{TH})V_{DS} - \frac{V_{DS}^2}{2}\right] \qquad \text{equation (1)}$$

from which the saturation current is

$$I^{sat}{}_D = \frac{W}{2L}\mu_p C_i\left[(V_{GS} - V_{TH})^2\right]$$

where $C_i$ is the capacitance per unit area of the gate insulator, $\mu$ is the charge-carrier mobility, and $V_{TH}$ is the threshold voltage.

From this equation, it is clear that several parameters can be tuned in order to obtain significant drain current with low voltages.

In US 2010/0135937, nanocrystalline forms of metal oxides, including binary metal oxide, perovskite type metal oxides, and complex metal oxides, including doped metal oxides, are provided. Methods of preparation of the nanocrystals are also provided. The nanocrystals, including uncapped and uncoated metal oxide nanocrystals, can be dispersed in a liquid to provide dispersions that are stable and do not precipitate over a period of time ranging from hours to months. Methods of preparation of the dispersions, and methods of use of the dispersions in forming films, are likewise provided. The films can include an organic, inorganic, or mixed organic/inorganic matrix. The films can be substantially free of all organic materials. The films can be used as coatings, or can be used as dielectric layers in a variety of electronics applications, for example as a dielectric material for an ultracapacitor, which can include a mesoporous material. Or the films can be used as a high-K dielectric in organic field-effect transistors. In various embodiments, a layered gate dielectric can include spin-cast (e.g., 8 nm-diameter) high-K $BaTiO_3$ nanocrystals and parylene-C for pentacene OFETs.

Applicant has noticed that the realization of such a film is rather complex due to the presence of the nanoparticles. Applicant has also noted the high K difference between the two layers, i.e. $BaTiO_3$ nanocrystals and parylene-C, used in the OFET.

In US 7029945, a process of manufacturing an organic field effect device is provided comprising the steps of (a) depositing from a solution an organic semiconductor layer; and (b) depositing from a solution a layer of low permittivity insulating material forming at least a part of a gate insulator, such that the low permittivity insulating material is in contact with the organic semiconductor layer, wherein the low permittivity insulating material is of relative permittivity from 1.1 to below 3.0. In addition, an organic field effect device manufactured by the process is provided. In some embodiments, two insulator layers are used, of permittivity higher than the low permittivity layer.

Applicant has noticed that the quality of organic dielectric films deposited by liquid phase should be inferior that the one obtained with other techniques, e.g. CVD, especially if nanometrical thickness is desired and, even more, if low k is used. In addition, generally a liquid deposition gives rise to films having relatively high thickness , i.e. above hundreds of nm, so, in case a low permittivity film is desired, the combination of low permittivity and high thickness give rises to low capacitance, low currents and high threshold voltages. In "Organic transistors manufactured using inkjet technology with subfemtoliter accuracy" written by Tsuyoshi Sekitani et al. and published in PNAS April 1, 2008, vol. 105, no. 13, pages 4977 onwards, it is written that a major obstacle to the development of organic transistors for large-area sensor, display, and circuit applications is the fundamental compromise between manufacturing efficiency, transistor performance, and power consumption. In the past, improving the manufacturing efficiency through the use of printing techniques has inevitably resulted in significantly lower performance and increased power consumption, while attempts to improve performance or reduce power have led to higher process temperatures and increased manufacturing cost. In this paper, the authors lift this fundamental limitation by demonstrating subfemtoliter inkjet printing to define metal contacts with single-micrometer resolution on the surface of high-mobility organic semiconductors to create high-performance p-channel and n-channel transistors and low-power complementary circuits. The transistors employ an ultrathin low-temperature gate dielectric based on a self-assembled monolayer that allows transistors and circuits on rigid and flexible substrates to operate with very low voltages.

Applicant has noted that in the OFET realized in this Article, the gate dielectric is based on a combination of a thin layer of aluminum oxide (3.6 nm thick) and a molecular self-assembled monolayer (SAM) of *n*-octadecylphosphonic acid (2.1 nm thick). The SAM layer is only a monolayer and cannot be thicker: indeed the SAM can be connected to the aluminum oxide layer thanks to a functionalized group which will not be of use on top on an already deposited SAM layer.

In "Low-Voltage High-Performance Pentacene Thin-Film Transistors With Ultrathin PVP/High-$\kappa$ HfLaO Hybrid Gate Dielectric", written by Woo Cheol Shin et al, and published in IEEE ELECTRON DEVICE LETTERS, VOL. 31, NO. 11, NOVEMBER 2010, pages 1308 onwards, low-voltage and high-performance pentacene thin film transistors with a hybrid gate dielectric consisting of ultrathin PVP (8 nm) and a high-$\kappa$ HfLaO (20 nm) have been demonstrated. The hybrid gate dielectric exploits the advantages of both dielectrics, i.e., a good interface between the organic dielectric and channel material as well as the insulating properties of the inorganic metal-oxide, resulting in very low leakage current, hysteresis-free behavior, superior drain-current drivability, and successful operation at -2 V. The superior device performance is attributed to good intermolecular ordering and the large grain size of the pentacene channel layer formed on the hybrid dielectric.

Applicant has noticed that HFLaO deposition requires a rather complex technique, such as Electron Beam Evaporation. High temperature treatment on HFLaO are also required (200°C), so only certain flexible substrate could be used for this application; in our approach, all the operation are performed at room temperature

Summary of the invention

The present invention aims at overcoming the problem of an undesired high operating voltage mentioned with reference to the prior art by the development of method for the fabrication of an organic transistor which includes a dielectric layer according to claim 1.

The organic transistor realized according to the method of the invention includes a gate, a source and a drain electrode. The channel is formed by an organic semiconductor, which can be any semiconductor used in the field for the realization of organic transistor. As examples, the organic semiconductor may include an aromatic or otherwise conjugated $\pi$-electron system, facilitating the delocalization of orbital wavefunctions. Electron withdrawing groups or donating groups can be attached that facilitate hole or electron transport. These aromatic or conjugated materials as active semiconducting layer may include small molecules such as rubrene, tetracene, pentacene, diindenoperylene, perylenediimides, tetracyanoquinodimethane, C60, quaterthiophene, $\alpha$-sexithiophene, $\alpha,\omega$-dihexylsexithiophene, polymers such as polythiophenes (especially poly 3-hexylthiophene), polyfluorene, polydiacetylene, poly 2,5-thienylene vinylene, poly p-phenylene vinylene, and all their derivatives. A preferred embodiment includes pentacene.

The thickness of the organic semiconductor layer is substantially not relevant to achieve the goal of the invention, a preferred embodiment includes an organic semiconductor layer having a thickness comprised between 5 nm and 50

nm, even more preferably between 10 nm and 20 nm. However also transistor having an organic semiconductor layer's thickness of 300 nm and above have been studied without seeing any appreciable variations in the performances with respect to those having a thinner layer.

As known, organic transistors generally also include an insulating gate dielectric layer between the gate electrode and the organic semiconductor.

The capacitance between the gate electrode and the source and drain electrodes is inversely proportional to the thickness of the dielectric layer, thus the voltage to be applied to the gate is higher the thicker the dielectric layer, in order to control the conductance of the channel. Therefore, in order to reduce the operating voltage of the organic transistor, a first possibility is to reduce the thickness of the dielectric layer.

However, reducing the thickness of the dielectric layer also reduces the resistance between gate and drain and source contacts, which increases the leakage of the transistor and therefore of the undesired currents. Considering a metal oxide film as a possible dielectric layer, the film is usually characterized by a very low vertical resistivity, which gives rise to very high leakage currents (currents that flows from the source electrode to the gate electrode). Moreover, the oxide film is usually characterized by a very high concentration of surface defects that normally increase charge carriers trapping, thus limiting mobility and increasing the OFET threshold voltage. As an example, Applicant has found that OFETs with ozone-obtained alumina layer are characterized by high leakage current and by a high concentration of interfacial defects, that acting as trapping sites for charge carriers strongly affect the threshold voltage and also the carrier mobility, moreover, the realization process shows a low efficiency.

Applicant has also found that the deposition of metal oxide thin films having a high uniformity and a low leakage requires very complex and expensive processes usually on rigid substrates. Indeed an additional goal of the present invention is to render available an organic transistor which is relatively easy to fabricate and which is highly reproducible at low cost. In addition, it is desired that the organic transistor of the invention can be realized on flexible substrates.

Applicant has also tested the possibility to deposit as dielectric layer a layer of dielectric polymer, for example parylene C, as better detailed below, but in order to achieve good insulating properties, the thickness of the polymeric layer has to be relatively high.

Applicant proposes an alternative fabrication procedure for obtaining an ultra-low voltage device than the one using SAM disclosed in the prior art that is simple, low-cost, and, most of all, very easily up-scalable to industrial size with a very high yield. These results have been achieved by employing a unique combination of different dielectric materials as dielectric layer that are able to give rise to high values of gate capacitances and create, at the same time, an efficient barrier to gate leakage and an optimal interface with the organic semiconductor, being this a key concept for optimizing the transistor performance, as better detailed and explained below.

According to the above, the transistor of the invention includes, between the organic semiconductor layer and the gate electrode, a dielectric layer which is "ultrathin" (the dimension of which will be better defined below), but at the same time, ensures a good electrical insulation and rigidity and can be fabricated also on plastic and more in general, flexible substrates.

This layer is a combination of two layers: a first layer which includes a metal oxide, called in the rest of this description a metal oxide layer and a second layer which includes a dielectric polymer, in the following called dielectric polymer layer. This second layer has to form the interface with the organic semiconductor, i.e. the polymer dielectric layer is in contact with the organic semiconductor above described.

The thickness $T_1$ of the metal oxide layer is comprised between $0 < T_1 \leq 20$ nm, preferably between $0 < T_1 \leq 10$ nm, more preferably 5 nm $\leq T_1 \leq$ 10 nm.

The layer may include preferably metal oxide of the general formula $M^1{}_xO_z$, or a complex mixed metal oxide of the formula $M^2{}_xM^3{}_yO_z$ wherein all of $M^1$-$M^3$ are independently selected ions of metallic elements. A metallic element refers to the identity of the element in any chemical form, i.e. a metallic element is an element classified as metallic which can be in the form of an elemental metal or can be in the form of a salt or complex of a metal. A metallic element in metallic form refers to the unoxidized metal, whereas a metallic element in salt or complex form refers to the metal in chemical combination with other elements.

A "metal oxide" include various species wherein the metal ion, although comprising an identical metallic element, is in a different oxidation state in distinct species, and thus is composed with different stoichiometry.

Preferred metals are for example Aluminum, Gallium, Indium, Zinc. In the described example, the metal oxide layer includes alumina (aluminum oxide).

The thickness $T_2$ of the dielectric polymer layer is comprised between $0 < T_2 \leq 50$ nm, preferably between $10 \leq T_2 \leq 30$ nm, more preferably 15 nm $\leq T_2 \leq$ 25 nm.

The second dielectric layer includes a dielectric polymer. This polymer is deposited via chemical vapor deposition (CVD). The dielectric polymer includes poly(p-xylylene), also known as parylene N of repeating unit

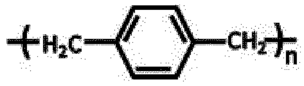

and its derivatives., Alternatively or in addition, the second layer includes halogenated parylene, preferably parylene C having repeating unit:

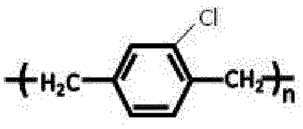

.

Other possible materials can be for example Poly(methyl methacrylate) (PMMA), Polyvinyl alcohol (PVA) or Polyvinylpyrrolidone (PVP), PolyStyrene (PS) and undoped PolyPyrrole (PPy).

The vacuum permittivity $\varepsilon_0$ (also called permittivity of free space or the electric constant) has the following value

$$\varepsilon_0 \stackrel{\text{def}}{=} \frac{1}{c_0^2\mu_0} = \frac{1}{35950207149.4727056\pi}\ \frac{\text{F}}{\text{m}} \approx 8.8541878176\ldots \times 10^{-12}\ \frac{\text{F}}{\text{m}}.$$

From the above, the relative permittivity $\varepsilon_r$ (also called dielectric constant of the material) of a material is defined as the ratio between its permittivity and the vaccum permittivity:

$$\varepsilon = \varepsilon_r\varepsilon_0 = (1+\chi)\varepsilon_0.$$

An additional characteristic of the transistor of the invention is thus the following: called $\varepsilon_1$ the relative permittivity of the material realizing the first dielectric metal oxide layer and $\varepsilon_2$ the relative permittivity of the material realizing the second dieletric polymer layer, the two permittivities satisfy the following equation:

$$|\varepsilon_1 - \varepsilon_2| \leq 10\,, \qquad \text{equation (2)}$$

preferably $|\varepsilon_1 - \varepsilon_2| \leq 6$.

Preferably, the first and second relative permittivity also satisfy the following equation:

$$\frac{1}{10} \leq \frac{\varepsilon_1 T_2}{\varepsilon_2 T_1} \leq 10\,, \qquad \text{equation (3)}$$

even more preferably, $\frac{1}{8} \leq \frac{\varepsilon_1 T_2}{\varepsilon_2 T_1} \leq 8$.

The thickness $T_1+T_2$ of the dielectric layer is still rather thin in order - as already explained - to increase the capacitance of the whole film, but also a very low leakage is achieved. This effect is obtained thanks to the combination of the properties of the metal oxide layer and of the polymer layer. In reality, the two layers are not completely separated: during the deposition of the polymer layer, the polymer itself might intermingle between the metal oxide molecules, interposing between them to form a sort of "unitary layer".

It is very important to notice that the charge transport in OFETs occurs within 1-2 nanometers of the semiconductor/ dielectric interface. Hence the properties of this buried interface, such as its roughness, defect and trap density, and orientation and interchain packing of the OFET molecules or macromolecules, is central to the device performance. Applicant has realized that a good interface between the semiconductor and the dielectric layer is therefore extremely important to obtain organic transistor having a low operating voltage: a non-optimal interface may lower the drain current of several orders of magnitude in comparison with identical transistors having a better interface. In addition, having a good interface between the dielectric layer and the organic semiconductor lowers the threshold voltage above which the transistor starts working. Applicant has noticed that a film of metal oxide as dielectric layer does not create an optimal

interface with the organic semiconductor. The same result is usually achieved when a double layer is formed where the permittivity of the two material is very different one from the other.

As a matter of fact, obtaining a high gate dielectric capacitance and keeping the leakage current density very low are necessary but not sufficient conditions in order to achieve very low operational voltages. Minimization of charge carriers trapping, which usually takes place at the interface between the gate dielectric and the organic semiconductor, plays an as much essential role in determining the operating voltages and the transport properties of the final device. Such defective sites cause a reduction of the semiconductor mobility but can also dramatically affect other electrical parameters, in particular threshold voltage and, as a consequence, the working voltages of the device. For these reasons, to obtain an ultra-low voltage device, a full control of all properties of the dielectric layers, not only thickness, is absolutely necessary.

A double layer according to the invention, in this thickness range (i.e. $0 < T_1 \leq 20$ nm and $0 < T_2 \leq 50$ nm) and satisfying eq. (2) and preferably also (3) enhances the insulating properties of the final dielectric film, thus strongly reducing the leakage current (increasing the vertical resistance). Moreover, if eq. (3) is satisfied, the final equivalent dielectric capacitance can be kept high enough to allow OTFTs to be operated at very low voltages. It has also been noticed that the presence of a second insulating layer, at the top of the metal oxide, dramatically improves the interfacial properties between gate dielectric and organic semiconductor. As a matter of fact, a second polymeric insulating film leads to a passivation of the high concentration of defective sites present on the metal oxide surface, strongly limiting charge carriers trapping.

The organic transistor of the invention preferably comprises a polymer layer the first relative permittivity ($\varepsilon_1$) of which is comprised between 8 and 15.

Preferably, the second relative permittivity ($\varepsilon_2$) is comprised between 3 and 10. Additionally, the fact that the dielectric polymer is preferably deposited via CVD is an advantage of the transistor of invention which allows a good reproducibility and does not require a complex set up in order to be realized. In addition, CVD guarantees an uniform and smooth deposition of the polymer layer even in very thin layers, which increases also the quality of the semiconductor/dielectric interface.

The transistor of the invention has preferably a bottom-gate, top/bottom contacts configuration, however other configurations can be envisaged. Preferably the gate is at the bottom so that the dielectric polymer can be grown on the metal oxide layer.

Preferably the transistor of the invention is an organic field effect transistor (OFET) or an Organic thin film transistor (OTFT).

The substrate on which the organic transistor is realized is a plastic flexible substrate, which can be later deformed and adapted to every generic surface on which the device should be assembled.

The organic transistor realized according to the invention can be used to realize low voltage sensors such as chemical sensors and biosensors. Alternatively or additionally, the organic transistor of the invention can be used to realize ambipolar organic transistor.

For example Parylene has a dielectric constant of 3.15 and the dielectric constant of the alumina layer is comprised between 8 and 10, depending on its quality.

## Brief description of the drawings

Further features and advantages of an organic transistor according to the invention will become more clearly apparent from the following detailed description thereof, given with reference to the accompanying drawings, where:

- FIG. 1 is a schematic lateral view in section of a preferred embodiment of the organic transistor of the invention;
- FIG. 2 is a schematic perspective view of the organic transistor of fig. 1;
- FIG. 3a and FIG. 3b are two schematic perspective views of two examples of an organic transistor according to the prior art and of an organic transistor according to the invention, respectively;
- FIG. 4a and FIG. 4b are two graphs showing the output and transfer characteristics of a transistor according to the prior art of fig. 3a;
- FIGS. 5a-5d are four graphs showing the output and transfer characteristics of an organic transistor realized according to the invention of figs. 1,2 and 3b for two different thicknesses of the dielectric layer;
- FIG. 6 is an histogram showing the resistivity and capacitance of dielectric layers according to the prior art and according to the invention;
- FIGS. 7a-7d are Atomic Force Microscopy micrographs of the transistor according to the prior art of fig. 3a, in particular of a detail of the dielectric layer (bare $Al_2O_3$ Fig. 7a) and of the organic semiconductor (Pentacene deposited on bare $Al_2O_3$ Fig. 7c); and of the transistor according to the invention of fig. 3b, in particular of a detail of the dielectric layer ($Al_2O_3$/Parylene C (300mg) Fig. 7b) and of the organic semiconductor (Pentacene deposited on $Al_2O_3$/Parylene C (300mg) Fig. 7d);

- FIGS. 8a-8d are graphs showing electrical characteristics of different embodiments of the invention fabricated using a double layer configuration $Al_2O_3$/Parylene (300mg) using different organic semiconductors.

Preferred embodiments of the invention

With initial reference to Figs. 1 and 2, an organic transistor according to the present invention is globally indicated with reference numeral 1.

In the appended drawings, the transistor is a low voltage OFET (or OTFT) having a bottom gate top contact configuration, however the teaching of the invention can be applied to other transistors and/or configurations as well.

The OFET is realized on a substrate 10 which can be any substrate, preferably it is a flexible plastic substrate. In the preferred embodiment, the substrate 10 includes polyethylene terephthalate (PET) which is transparent and flexible.

The OFET 1 includes a gate 5, a drain 6 and a source 7 electrodes. The material in which the electrodes are realized can be any known material suitable for the purpose and known in the specific technical field, for example gold, aluminum, Poly(3,4-ethylenedioxythiophene) (PEDOT), PEDOT:PSS, silver. Preferably, for the gate is realized in Aluminum, while the drain and source contacts in Gold.

The gate 5 is realized preferably by thermal evaporation, sputtering, spin coating or printing. The profile of the gate contact can be obtained with a shadow mask or with subtractive methods such as photolithography in order to increase definition and resolution.

On top of the gate, the dielectric layer is realized 2. According to the invention, the dielectric layer is realized using a combination of a metal oxide layer 3 and a dielectric polymer layer 4, one on top of the other.

In this embodiment, advantageously, the metal oxide layer 2 is realized in alumina using the oxidation of the aluminum layer deposited to create the gate electrode. Therefore this first dielectric layer can be obtained using a very simple process step. This oxidation step can be used also with other metals in addition to Aluminum.

It is well known that Aluminum films, when exposed to ambient atmosphere get naturally oxidized, even at room temperature. The native oxide is usually irregular and porous, and also characterized by a low electrical rigidity. Therefore, these thin native Aluminum Oxide (Alumina) films are not generally suitable for the fabrication of dielectric films for the fabrication of Field Effect Transistors. It is noteworthy that the tendency of Aluminum to get easily oxidized, can be exploited by employing different techniques that can speed up the oxidation process and dramatically improve the quality of the final film. In this way, very thin alumina film with good electrical performances, in particular in terms of electrical rigidity, can be fabricated. Among several techniques that usually requires very sophisticated facilities, Applicant has used a different approach that doesn't require sophisticated laboratory equipment and it is simple to be performed. This approach consists in exposing fresh aluminum films to ozone atmosphere, where ozone can be very easily produced for example by using a mercury lamp with a proper wavelength (UV-lamp). Ozone oxidation with an UV-lamp can be performed at room temperature and at open air; in order to increase the aluminum oxide thickness and to increase the oxide regularity, multiple consecutive oxidation sessions can be performed.

It has to be understood that other techniques for the realization of the metal oxide layer, as well as other metal(s) as well, can be used, for example anodization, oxygen plasma etc.

In this way, a very thin metal oxide film 3 has been fabricated at the top of the gate electrode 5.

At the top of Aluminum Oxide layer, an additional layer made of insulating polymer 4 is realized. This double layer configuration allows on one hand shielding surface defects of the metal oxide layer, thus strongly limiting charge trapping, on the other hand to dramatically increase vertical resistivity thus almost cancelling current leakage through the gate dielectric.

As an example, the transistor 1 of the invention includes a polymer layer 4 comprising a biocompatible, insulating material called Parylene C.

The Parylene C layer is deposited, preferably by Chemical Vapor Deposition. The combination of metal oxide layer and dielectric polymer layer, as stated before, permitted to obtain a dielectric with optimal electrical proprieties: the OFET realized with this double dielectric structure shows very low leakage currents and higher carrier mobility, due to the passivation of surface trap centers performed by the dielectric polymer. Moreover, the final insulating film thickness is still thin enough to allow the OFETs working at very low voltages.

At the top of this structure, source and drain electrodes can be fabricated using different patterning techniques (photolithography, metal deposition through shadow masks, inkjet printing etc.) and a thin film of a proper organic semiconductor can be deposited in order to have the final OFET structure completed.

Possible materials for the realization of these electrodes are gold, silver, PEDOT:PSS. Preferably they are both including gold.

Importantly enough, the layer of polymer 4 works also as protection for the first metal oxide layer 3 and for the gate 5, which can be normally affected by the following fabrication steps such as the photoresist development and etching. This step, therefore, dramatically improved fabrication yield of OFETs.

The final step, consisted in the deposition of the organic semiconductor 9. This semiconductor 9 can be of any

type known in the art for this specific application. As detailed below, the proposed structure has been studied with several different semiconductor deposited by different techniques, for example thermal vapor deposition (pentacene), drop casting (pentacene TIPS) and spin coating (Polyera N1400); for solution-processable organic semiconductors (pentacene TIPS and Polyera N1400) different solvents have been used. For each semiconductor, reproducible results have been obtained, demonstrating the applicability of the structure to different kind of molecules, processed with different kind of methods involving different kind of chemical products.

Comparative example

Organic transistors 100 based on a bare $Al_2O_3$ dielectric film (i.e. an organic transistor including a dielectric layer which includes a metal oxide layer only and no polymer layer, as depicted in fig. 3a) have been realized and their complete characterization as thin film transistors has been carried out.

More in detail, the realized OFETs structures are all bottom-gate/bottom contact. The aluminum gate 5 is realized by thermal evaporation of aluminum on a flexible, transparent PET substrate 10. The gate contact 5 is patterned using a shadow mask or by the mean of photolithographic process. The $Al_2O_3$ layer 3 is realized at room temperature by the means of UV-Ozone oxidation, performed in ambient conditions; ozone was obtained by a mercury lamp (UV Penray). The oxidation process consists of two different steps of oxidation of 30 minutes, separated by a relaxation time of 24 h. Source and Drain contact 6,7 are realized with a photolithographic process performed on gold thermally evaporated on top of the $Al_2O_3$ layer 3.

Drain-source current ($I_D$) measurements were carried out at room temperature in air. An Agilent HP 4155 Semiconductor Parameter Analyzer, provided with gold tips for contacting the electrodes, was used to control the gate voltage ($V_G$) and the drain-source voltage ($V_D$) and to measure $I_D$ (the source being the common ground).

For all devices, both mobility and threshold voltage were derived from the transfer characteristics in the saturation regime. Since the hysteresis was negligible for all devices, mobility and threshold voltage have the same value both in forward and backward gate voltage sweep.

Atomic Force Microscopy measurements were obtained by means of a SPM SOLVER PRO by NT-MDT in semi-contact mode.

Capacitive measures were performed using an Agilent 4284A impedance analyzer, that permits to realize 6-digit precision measures in the range between 20Hz and 1MHz and voltage-sweep measures at fixed frequencies.

Different samples have been prepared, the difference being the thickness of the dielectric layer 3, indeed different UV-Ozone exposure times have been tested, from 10 to 60 minutes, obtaining $Al_2O_3$ films ranging 2.5 nm up to 9.2 nm.

In fig. 6 the Resistance and the Capacitance of a $Al_2O_3$ films having a thickness of 2.5 nm and of 9.2 nm are shown (the first two histograms on the far left).

The results of the electrical characterization of OFET are plotted in figs. 4a and 4b, in which it could be observed that, thanks to the very high gate dielectric capacitance ($3.5\mu F/cm^2$), the fabricated OTFTs usually show a very good field effect behavior with operational voltages lower than 2V.

In particular figs. 4a and 4b shows the output and transfer characteristics in the saturation regime, at $V_{DS}$=-2V, for the OFET of fig. 3a with a thickness of the dielectric layer equal to 2.5 nm.

However, some significant drawbacks can be pointed out. In particular, a very high off-current (which dramatically reduces the $I_{on}/I_{off}$ ratio) and a very pronounced leakage current from gate to source. Not less important, the final yield of the procedure is very low, ranging around 5-10% of working devices (on several tens of devices). The main reason for such a high failure rate can be mainly ascribed to the very low vertical resistance and dielectric strength of $Al_2O_3$ films that cause a short circuit between the metal contacts even when a very low voltage (1 V) is applied across the dielectric layer. A further increase in the UV-Ozone exposure time leads to saturation of the final $Al_2O_3$ film thickness, without significantly improving its vertical resistivity.

Example 1

Fig. 3b is a schematic representation of OFETs fabricated using a double dielectric layer, i.e. not only a single, UV-Ozone grown, $Al_2O_3$ film as in fig. 3a, but a double layer 2 configuration in which a thin Parylene C film 4 is deposited at the top of the previously grown $Al_2O_3$ film 3.

Parylene C is deposited by the mean of CVD (Specialty Coating Systems) at room temperature.

Different amounts of Parylene C have been employed in this investigation, starting from 30 mg up to 300 mg, in order to achieve a good trade-off between process yield and electrical properties of the final devices (threshold voltage, mobility and leakage). The goal of this procedure was, on one hand, a "sealing" of the leakage paths across the oxide without a significant decrease of the dielectric capacitance, on the other hand, an improvement of the interface with the organic semiconductor, since $Al_2O_3$ usually does not give rise to an ideal surface for the fabrication of OTFTs. In this

specific example, the first dielectric layer is a 60 min UV-Ozone grown $Al_2O_3$ film (nominal thickness 9.2 nm). The parylene layer capacitance is linearly dependent on the amount of polymer introduced in the CVD reactor that, clearly, is not entirely deposited on the device area but is spread everywhere within the CVD chamber. Even if this linear relation has been obtained on pure parylene layers (and only for relatively thick layers, as for small amounts (i.e. < 800 mg) it is not possible to obtain a measurable capacitor due to the high leakage), it is reasonable to state that this same linear relation may be used for estimating the thickness of the parylene layer deposited. However, this is an overestimation in the case of small amounts of parylene because it does not take into account that part of the parylene penetrates into the oxide layer. Therefore parylene layers have been characterized in terms of weight of the precursor polymer introduced in the CVD chamber.

As shown in Fig. 9, it is clear that a deposition of parylene on the alumina film drastically lowers the capacitance value of the whole layer (alumina + parylene), confirming that an insulating layer has been deposited, however up to 120 mg the vertical resistance is substantially similar to that of the alumina layer alone. Indeed, for very small amounts of parylene C dimer (data not shown), no significant improvement in the electrical performances has been shown. In contrast, a dramatic difference in the OTFT behavior can be observed for amounts higher than 150 mg. Above this value, again as shown in FIG. 9, a significant increase in the resistance value is also present.

In figs. 5a and 5b, the output and transfer characteristics of OFETs fabricated using a double layer 2 $Al_2O_{3/}$Parylene C configuration, using an amount of Parylene C dimer equal to 150 mg are shown. In figs. 5c and 5d the same quantities are shown for a Parylene C dimer amount of 300 mg. The transfer characteristics have been recorded in the saturation regime at $V_{DS}$=-2V (Fig. 5b) and at $V_{DS}$=-1V (Fig. 5d) for 150 mg and 300 mg Parylene C devices respectively.

As can be noticed from the comparison between the graphs depicted for the OFET realized with a single layer of $Al_2O_3$ (see Fig. 4a-4b) and also reported in Table 1, in the OFETs having a double layer according to the invention with a parylene C dimer equal to 150 mg, a dramatic drop of the dielectric leakage in the measurements was observed; moreover, a significant shift towards zero of the threshold voltage and a significant increase in the holes mobility were also observed in comparison with the values obtained for bare $Al_2O_3$ based devices.

However, also in this case, the reproducibility of the process is still relatively scarce, and a 20% rate of success was obtained. The low degree of reproducibility observed in these samples might be mainly ascribed to the reproducibility of the Parylene C deposition process.

In order to improve the process yield, OTFTs using a slightly higher amount of Parylene C dimer, namely 300 mg have been realized. It is noteworthy that in this case a further reduction of $V_T$ has been observed (see figs. 5c and 5d) and also a significant increase of the process yield, up to 90%. Not less importantly, it must be underlined that the presence of the parylene C film also led to a tremendous reduction of the leakage current density (more than 2 orders of magnitude), that usually ranges around $5x10^{-10}$ $A/cm^2$. Moreover, as can be noticed from the transfer characteristics reported in Fig. 5b and 5d, the gate current has a stable behavior along the whole working range of the device, indicating that no breakdown occurs in the dielectric for these values of the gate electric field.

Atomic Force Microscope (AFM) investigations have also been performed and the results are shown in Figs. 7a-7d. Fig. 7a is a micrograph of bare $Al_2O_3$, Fig. 7b of Al2O3/Parylene C (300mg) films, Fig. 7c Pentacene deposited on bare $Al_2O_3$ and Fig. 7d Pentacene deposited on $Al_2O_3$/Parylene C (300mg).

$Al_2O_3$ film is characterized by a very high surface corrugation (fig. 7a), namely by a Surface Root Mean Squared Roughness (RMSR) of around 5.5 nm. Parylene C film acts as a smoothing layer, allowing a dramatic reduction of the surface corrugation (down to 1.3 nm) (see Fig 7b) which, in turns, leads also to a clear improvement in the final Pentacene film morphology (see the difference between figs. 7c and 7d). The average grain dimension of Pentacene increases from around 100 nm when deposited on top of $Al_2O_3$ to 500 nm when deposited on top of $Al_2O_3$/Parylene C. The variation in the grain average dimension seems coherent with the significant increase (more than one order of magnitude) of carriers mobility in the two different cases (see Table 1).

The relative permittivity of the layers are 3.15 for Parylene and about 9 for the alumina layer.

TABLE 1

| Insulating Structure | Capacitance [F/cm$^2$] | IG [A] | Vt [V] | μ [cm$^2$/Vs] | S [mV/dec] | N [cm$^{-2}$eV$^{-1}$] | OTFTs Yield [%] |
|---|---|---|---|---|---|---|---|
| $Al_2O_3$ (ET: 10 min) | (3.5±0.4) 10-6 | (6,±1) E-6 | -1.2±0.1 | (3.3±0.9) E-3 | (361 ± 141) | (1.1±0.6) E14 | 15% |
| $Al_2O_3$ (ET: 60 min) +150mg Parylene | (1.6±0.3) 10-7 | (2.6±0.4) E-9 | -0.8±0.1 | (3.5±0.6) E-2 | (266 ± 113) | (3.4±2.6) E12 | 15% |

(continued)

| Insulating Structure | Capacitance [F/cm$^2$] | IG [A] | Vt [V] | μ [cm$^2$/Vs] | S [mV/dec] | N [cm$^{-2}$eV$^{-1}$] | OTFTs Yield [%] |
|---|---|---|---|---|---|---|---|
| $Al_2O_3$ (ET: 60 min) +300mg Parylene | (1.3±0.1) 10-7 | (4±2)E-10 | -0.5±0.1 | (2.3±0.8) E-2 | (358 ± 84) | (4 ± 1.4) E12 | 90% |

Example 2

Different organic semiconductors 1 have been realized having the same structure depicted in figs. 2 and 3b but with different organic semiconductors 9, namely 6,13-Bis(triisopropylsilylethynyl)-pentacene, TIPS-pentacene (Sigma Aldrich, p-type), and N1400 (Polyera, n-type). These results are presented in figs. 8a-8d, where electrical characteristics of OFETs fabricated using a double layer configuration $Al_2O_3$/Parylene (300mg) using different organic semiconductors are depicted: output and transfer characteristics in the saturation regime for TIPS (Fig. 8a and Fig. 8b), and N1400 (Fig. 8c and Fig.8d) based OFETs are shown.

These graphs demonstrate that the dielectric combination "metal oxide layer - dielectric polymer layer" is able to generate an optimized interface also with soluble p-type (as TIPS-pentacene) and with n-type materials (as N1400). This is particularly interesting since it demonstrate that the Parylene C film is characterized by a low concentration of electron sites traps, and is able to act as an efficient shield for electron trapping sites usually present on oxides surfaces such as $Al_2O_3$, allowing n-type transport.

Additional values of the OFETs realized are detailed in Table 2:

TABLE 2

| Semiconductor | Mobility [cm2/Vs] | Vt [V] | SubthSlope [mV/dec] | Ig [A] |
|---|---|---|---|---|
| *Pentacene* | (2.3±0.8) E-2 | -0.47 ± 0.1 | 358 ± 84 | [4.1±2.3] E-10 |
| *TIPS-Pentacene* | (5.3±3.1) E-2 | -0.51 ± 0.19 | 136 ± 20 | |
| *N1400* | (1.1±0.6) E-3 | -0.28 ± 0.16 | 365 ± 202 | |

Only one value for the leakage current has been reported because this parameter is not dependent on the employed organic semiconductor, but it only depends on the insulating properties of the gate dielectric.

The data concerning the leakage current ($I_g$) have been measured from the output curves at Vgs=-1V and $V_{ds}$=-1V.

It is important to highlight that the reported $I_g$ values are affected by a parasitic capacitive effect that mainly depends on the superposition of source/drain contacts with the gate (and therefore has nothing to do with real leakage). As this effect depends on the time derivative of Voltage, it can be lowered and almost cancelled by performing very slow measurements (increasing Hold Time and Delay Time). For instance, in this way it was possible to reduce the leakage current by a factor of 5 (lower than 100pA). Since not all the devices have been characterized by performing very slow measurements, we report the average values obtained in normal conditions (HT=0s and DT=0s).

Applicant has shown that the organic transistor of the invention works with bias voltages of less than 1 V; and within its working voltage range does not show any significant leakage. In addition, the fabrication technique of the transistor of the invention is able to give rise to a process yield of more than 90% in standard conditions and therefore has very interesting potential in terms of industrial scalability.

## Claims

**1.** Method for the fabrication of an organic transistor (1) onto a flexible plastic substrate (10), said transistor comprising the steps of:

- Forming, onto a gate electrode (5), a dielectric layer (2), using a combination of a metal oxide layer (3) and a dielectric polymer layer (4), including:

  ◦ Forming at the top of said gate electrode said metal oxide layer (3) having a first thickness ($T_1$) comprised between 0 nm < $T_1$ ≤ 20 nm and having a first relative permittivity ($\varepsilon_1$),

◦ Depositing by chemical vapor deposition (CVD) said dielectric polymer layer having a second thickness ($T_2$) comprised between 0 nm < $T_2 \leq 50$ nm, said dielectric polymer layer (4) having a second relative permittivity ($\varepsilon_2$) and forming an interface with said organic semiconductor (9), wherein said dielectric polymer layer (4) includes poly(p-xylylene) and/or its derivatives or halogenated parylene;
◦ Wherein said first and second relative permittivity satisfy the following equation:

$$|\varepsilon_1 - \varepsilon_2| \leq 10.$$

- Fabricating on said dielectric polymeric layer (4) a source (6) and a drain (7) electrodes,
- Depositing on said electrodes a layer of an organic semiconductor (9).

**2.** The method of any of the previous claims, wherein said first thickness is comprised between $0 < T_1 \leq 10$ nm.

**3.** The method of claim 2, wherein said first thickness is comprised between 5 nm $\leq T_1 \leq$ 10 nm.

**4.** The method of any of the previous claims, wherein said second thickness is comprised between $10 \leq T_2 \leq 30$ nm.

**5.** The method of claim 4, wherein said second thickness is comprised between 15 nm $\leq T_2 \leq$ 25 nm.

**6.** The method of any of the previous claims, wherein said metal oxide layer (3) includes alumina.

**7.** method of any of the previous claims, wherein said first relative permittivity ($\varepsilon_1$), is comprised between 8 and 15.

**8.** The method of any of the previous claims, wherein said second relative permittivity ($\varepsilon_2$), is comprised between 3 and 10.

**9.** The method of any of the previous claims, wherein said first and second relative permittivity satisfy the equation

$$\frac{1}{8} \leq \frac{\varepsilon_1 T_2}{\varepsilon_2 T_1} \leq 10.$$

**10.** The method of claim 9, wherein said first and second relative permittivity satisfy the equation

$$\frac{1}{8} \leq \frac{\varepsilon_1 T_2}{\varepsilon_2 T_1} \leq 8 \quad .$$

**11.** The method of any of the previous claims, wherein said first and second relative permittivity satisfy the following equation:

$$|\varepsilon_1 - \varepsilon_2| \leq 6.$$

**12.** The method of any of the previous claims, wherein said transistor is an organic field effect transistor (OFET) or an organic thin film transistor (OTFT).

**13.** The method of any of the previous claims, wherein said organic semiconductor layer (9) includes pentacene.

**Patentansprüche**

**1.** Verfahren zur Herstellung eines organischen Transistors (1) auf einem flexiblen Kunststoffsubstrat (10), wobei der Transistor die folgenden Schritte umfasst:

- Bilden einer dielektrischen Schicht (2) auf einer Gate-Elektrode (5), unter Verwendung einer Kombination aus einer Metalloxidschicht (3) und einer dielektrischen Polymerschicht (4), einschließlich:

◦ Bilden der Metalloxidschicht (3) auf der Gate-Elektrode, mit einer ersten Dicke ($T_1$), die im Bereich zwischen 0 nm < $T_1 \leq 20$ nm liegt, und einer ersten relativen Dielektrizitätszahl ($\varepsilon_1$),
◦ Abscheiden der dielektrischen Polymerschicht mit einer zweiten Dicke ($T_2$), die im Bereich zwischen 0 nm < $T_2 \leq 50$ nm liegt, mittels chemischer Dampfabscheidung (CVD), wobei die dielektrische Polymerschicht (4) eine zweite relative Dielektrizitätszahl ($\varepsilon_2$) aufweist, und Bilden einer Grenzfläche mit dem organischen Halbleiter (9), wobei die dielektrische Polymerschicht (4) Poly(p-xylylen) und/oder dessen Derivate oder halogeniertes Parylene beinhaltet;
◦ worin die erste und zweite relative Dielektrizitätszahl die folgende Gleichung erfüllen:

$$|\varepsilon_1 - \varepsilon_2| \leq 10.$$

- Herstellen auf der dielektrischen Polymerschicht (4) einer Source- (6) und einer Drain- (7) Elektrode,
- Abscheiden einer Schicht eines organischen Halbleiters (9) auf den Elektroden.

**2.** Verfahren nach einem der vorstehenden Ansprüche, wobei die erste Dicke im Bereich zwischen $0 < T_1 \leq 10$ nm liegt.

**3.** Verfahren nach Anspruch 2, wobei die erste Dicke im Bereich zwischen 5 nm $\leq T_1 \leq$ 10 nm liegt.

**4.** Verfahren nach einem der vorstehenden Ansprüche, wobei die zweite Dicke im Bereich zwischen $10 < T_2 \leq 30$ nm liegt.

**5.** Verfahren nach Anspruch 4, wobei die zweite Dicke im Bereich zwischen 15 nm $\leq T_2 \leq$ 25 nm liegt.

**6.** Verfahren nach einem der vorstehenden Ansprüche, wobei die Metalloxidschicht (3) Aluminiumoxid beinhaltet.

**7.** Verfahren nach einem der vorstehenden Ansprüche, wobei die erste relative Dielektrizitätszahl ($\varepsilon_1$) im Bereich zwischen 8 und 15 liegt.

**8.** Verfahren nach einem der vorstehenden Ansprüche, wobei die zweite relative Dielektrizitätszahl ($\varepsilon_2$) im Bereich zwischen 3 und 10 liegt.

**9.** Verfahren nach einem der vorstehenden Ansprüche, wobei die erste und die zweite relative Dielektrizitätszahl die Gleichung $\frac{1}{8} \leq \frac{\varepsilon_1 T_2}{\varepsilon_2 T_1} \leq 10$ erfüllen.

**10.** Verfahren nach Anspruch 9, wobei die erste und die zweite relative Dielektrizitätszahl die Gleichung $\frac{1}{8} \leq \frac{\varepsilon_1 T_2}{\varepsilon_2 T_1} \leq 8$ erfüllen.

**11.** Verfahren nach einem der vorstehenden Ansprüche, wobei die erste und die zweite relative Dielektrizitätszahl die folgende Gleichung erfüllen: $|\varepsilon_1\text{-}\varepsilon_2| \leq 6$.

**12.** Verfahren nach einem der vorstehenden Ansprüche, wobei der Transistor ein organischer Feldeffekttransistor (OFET) oder ein organischer Dünnfilmtransistor (OTFT) ist.

**13.** Verfahren nach einem der vorstehenden Ansprüche, wobei die organische Halbleiterschicht (9) Pentacen beinhaltet.

## Revendications

**1.** Méthode de préparation d'un transistor organique (1) sur un substrat en plastique flexible (10), ledit transistor

comprenant les étapes consistant à :

- former, sur une électrode de grille (5), une couche diélectrique (2), en utilisant une combinaison d'une couche d'oxyde métallique (3) et d'une couche de polymère diélectrique (4), comprenant :

  ◦ la formation en haut de ladite électrode de grille de ladite couche d'oxyde métallique (3) présentant une première épaisseur ($T_1$) comprise entre 0 nm < $T_1 \leq 20$ nm et présentant une première permittivité relative ($\varepsilon_1$),
  ◦ le dépôt, par dépôt chimique en phase vapeur (DCV) de ladite couche de polymère diélectrique présentant une deuxième épaisseur ($T_2$) comprise entre 0 nm < $T_2 \leq 50$ nm, ladite couche de polymère diélectrique (4) présentant une seconde permittivité relative ($\varepsilon_2$) et formant une interface avec ledit semi-conducteur organique (9), dans laquelle ladite couche de polymère diélectrique (4) comprend du poly(p-xylylène) et/ou ses dérivés ou du parylène halogéné ;

dans laquelle, lesdites première et seconde permittivités relatives satisfont à l'équation suivante :

$$|\varepsilon_1 - \varepsilon_2| \leq 10 .$$

- fabriquer sur ladite couche polymère diélectrique (4) des électrodes de source (6) et de drain (7),
- déposer sur lesdites électrodes une couche d'un semi-conducteur organique (9).

2. Méthode selon l'une quelconque des revendications précédentes, dans laquelle ladite première épaisseur est comprise entre 0 < $T_1 \leq 10$ nm.

3. Méthode selon la revendication 2, dans laquelle ladite première épaisseur est comprise entre 5 nm $\leq T_1 \leq$ 10 nm.

4. Méthode selon l'une quelconque des revendications précédentes, dans laquelle ladite seconde épaisseur est comprise entre $10 \leq T_2 \leq 30$ nm.

5. Méthode selon la revendication 4, dans laquelle ladite seconde épaisseur est comprise entre 15 nm $\leq T_2 \leq$ 25 nm.

6. Méthode selon l'une quelconque des revendications précédentes, dans laquelle ladite couche d'oxyde métallique (3) comprend de l'alumine.

7. Méthode selon l'une quelconque des revendications précédentes, dans laquelle ladite première permittivité relative ($\varepsilon$1) est comprise entre 8 et 15.

8. Méthode selon l'une quelconque des revendications précédentes, dans laquelle ladite seconde permittivité relative ($\varepsilon_2$) est comprise entre 3 et 10.

9. Méthode selon l'une quelconque des revendications précédentes, dans laquelle lesdites première et seconde permittivités relatives satisfont à l'équation :

$$\frac{1}{8} \leq \frac{\varepsilon_1 T_2}{\varepsilon_2 T_1} \leq 10 .$$

10. Méthode selon la revendication 9, dans laquelle lesdites première et seconde permittivités relatives satisfont à l'équation :

$$\frac{1}{8} \leq \frac{\varepsilon_1 T_2}{\varepsilon_2 T_1} \leq 8 .$$

11. Méthode selon l'une quelconque des revendications précédentes, dans laquelle lesdites première et seconde permittivités relatives satisfont à l'équation suivante :

$$|\varepsilon_1 - \varepsilon_2| \leq 6.$$

**12.** Méthode selon l'une quelconque des revendications précédentes, dans laquelle ledit transistor est un transistor organique à effet de champ (OFET) ou un transistor organique en couche mince (OTFT).

**13.** Méthode selon l'une quelconque des revendications précédentes, dans laquelle ladite couche de semi-conducteur organique (9) comprend du pentacène.

FIG. 1

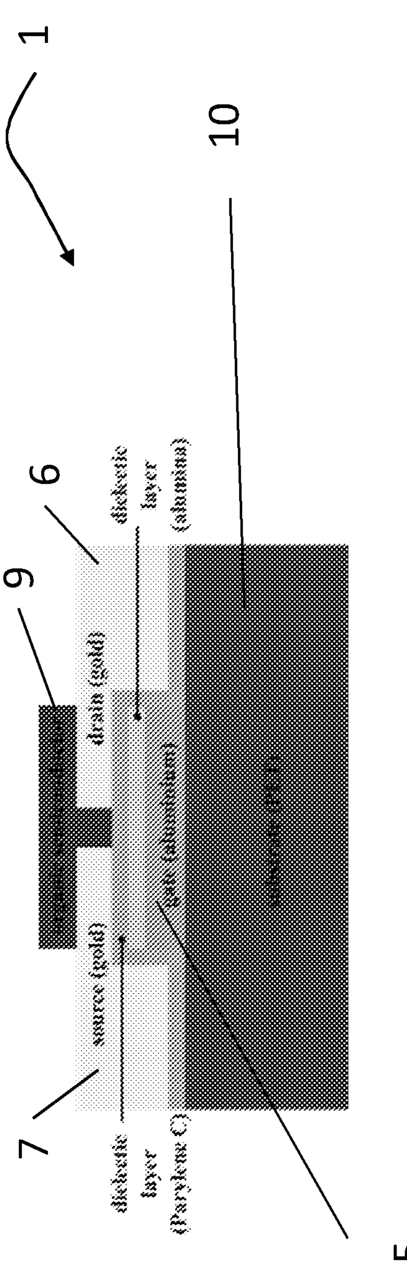
1
9
6
10
7
5
source (gold)
drain (gold)
gate (aluminium)
substrate (PET)
dielectric layer (Parylene C)
dielectric layer (alumina)

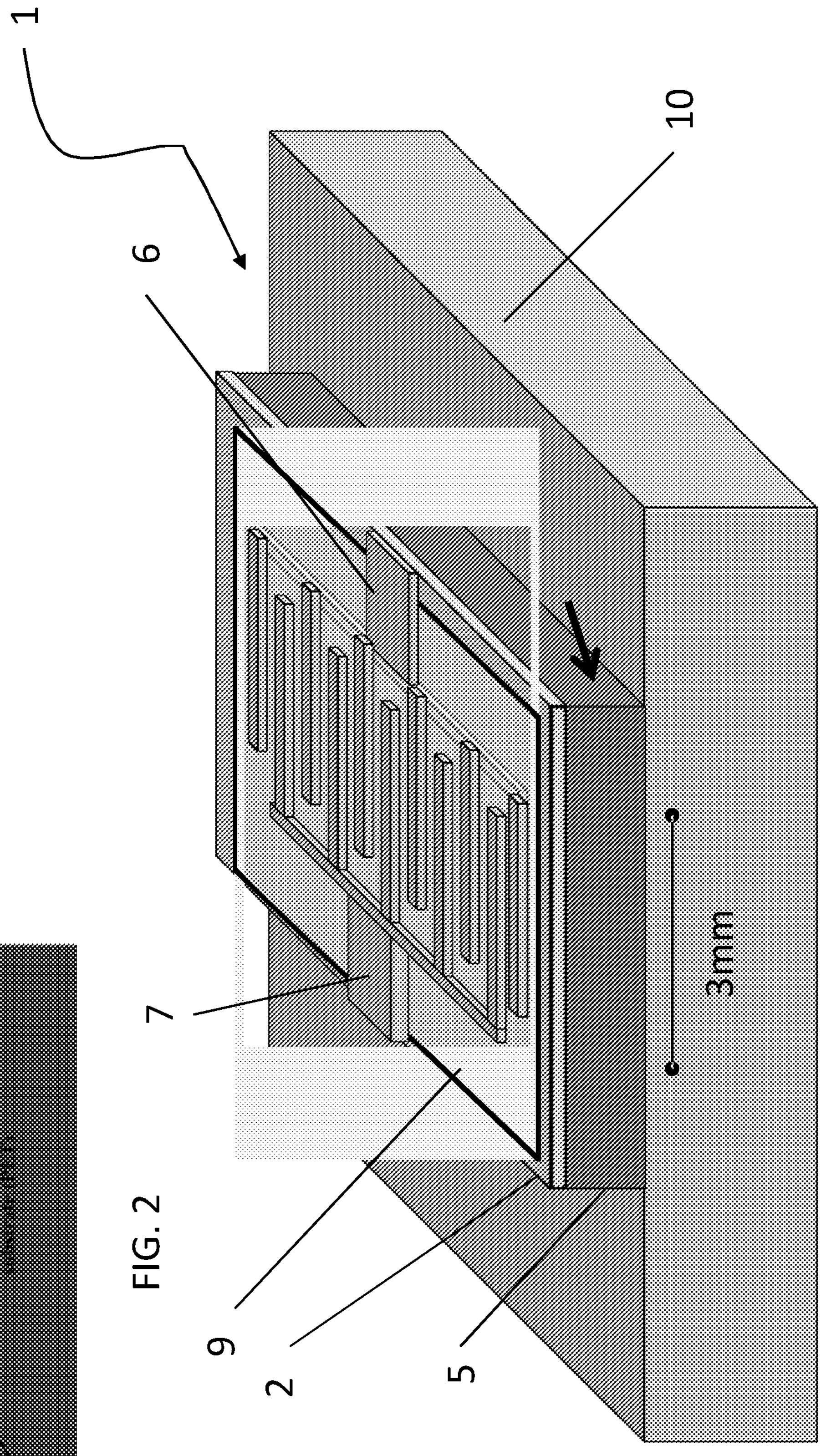
1
6
10
7
9
2
5
3mm

FIG. 2

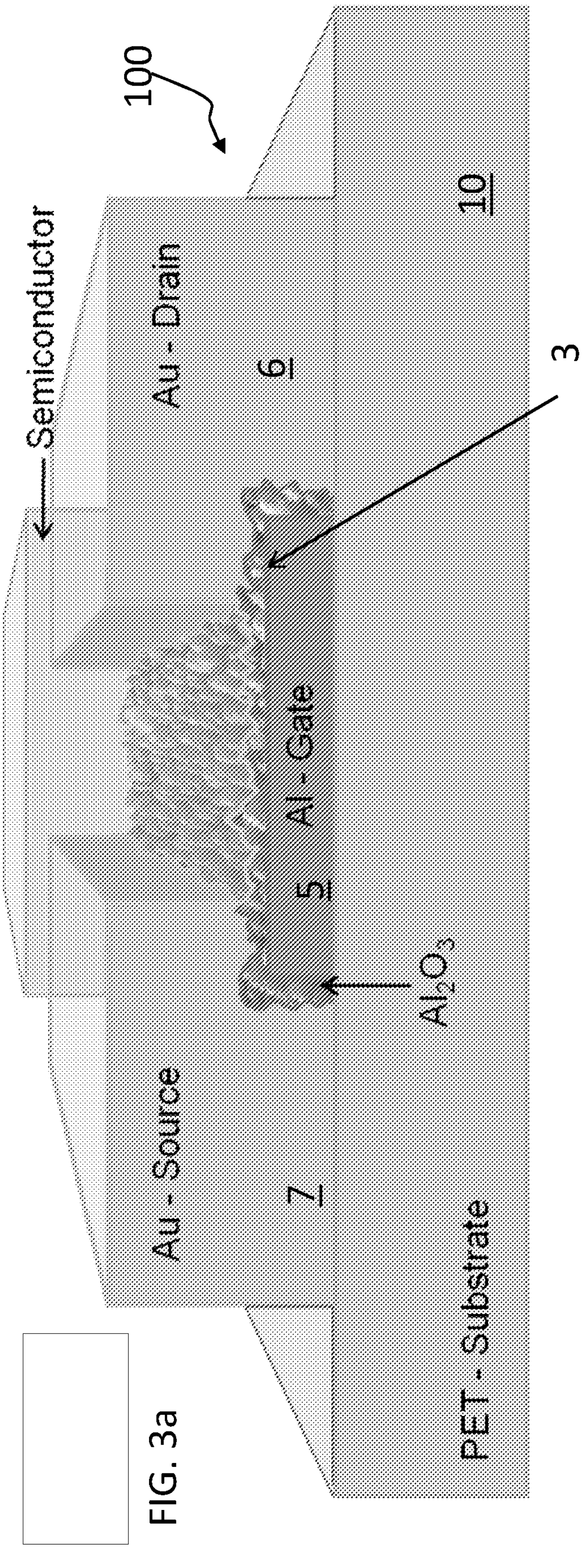
100
Semiconductor
Au - Drain
6
3
10
Al - Gate
5
Al$_2$O$_3$
Au - Source
7
PET - Substrate

FIG. 3a

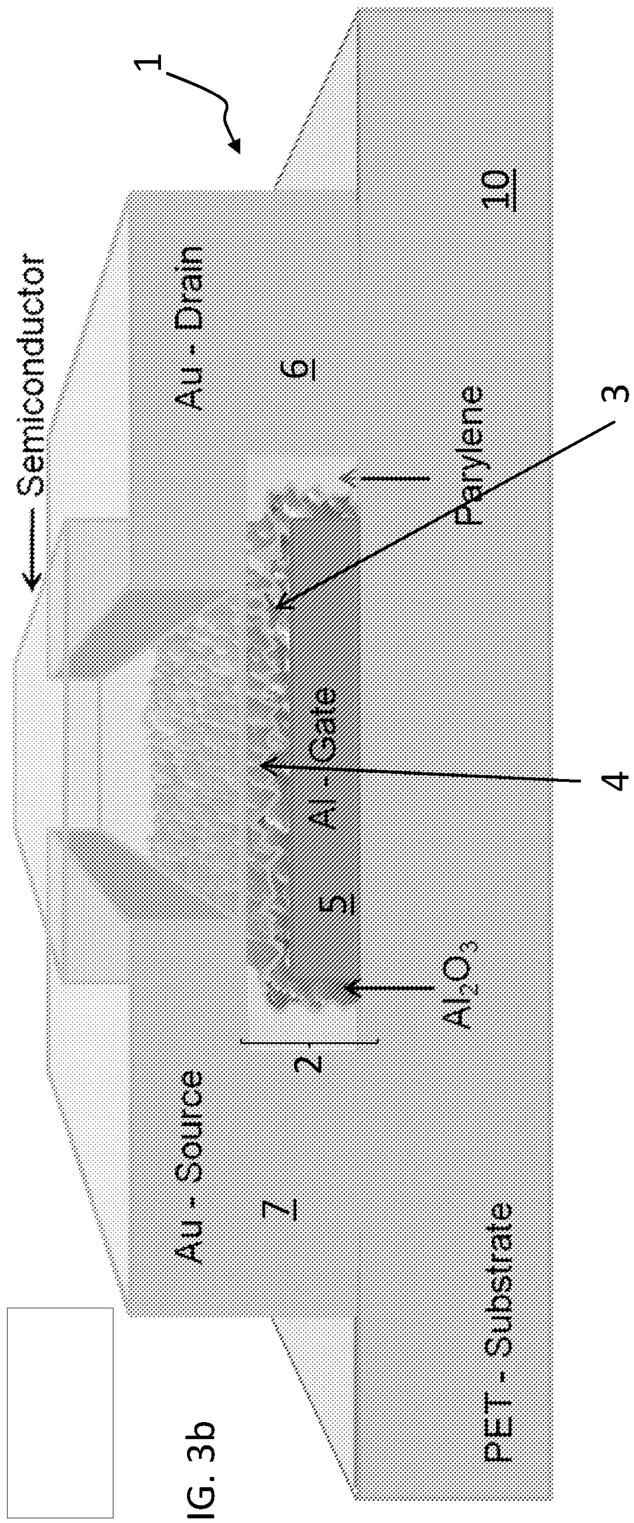
1
Semiconductor
Au - Drain
6
10
Parylene
3
4
Al - Gate
5
Al$_2$O$_3$
2
Au - Source
7
PET - Substrate

FIG. 3b

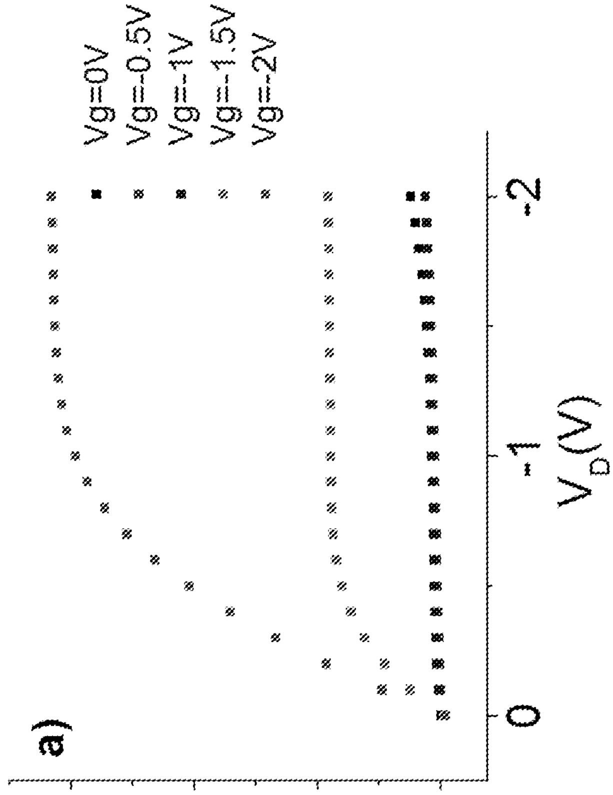

a)
Vg=0V
Vg=-0.5V
Vg=-1V
Vg=-1.5V
Vg=-2V
$I_D$(A)
-6μ
-4μ
-2μ
0
0
-1
-2
$V_D$(V)


FIG. 4a

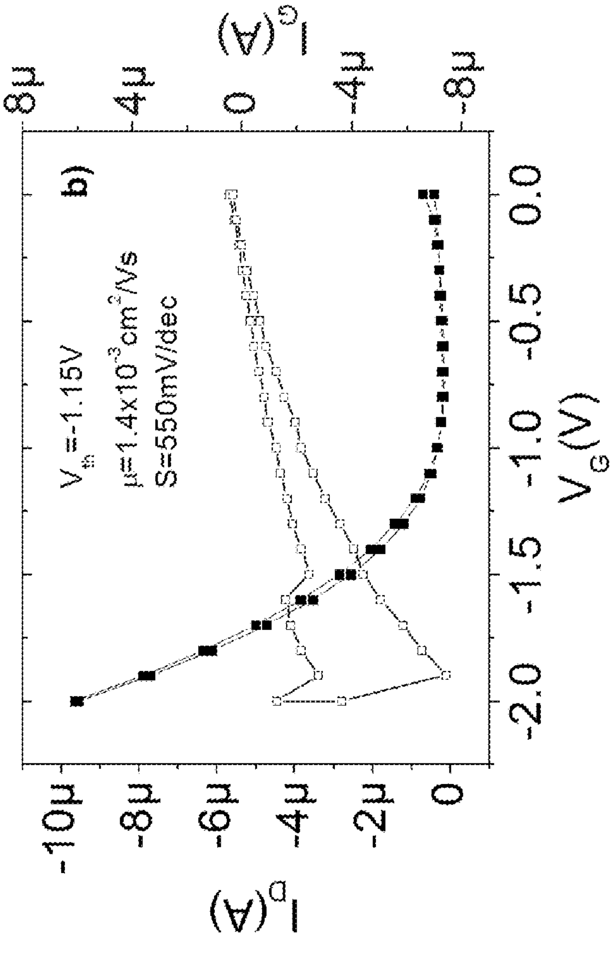

b)
$V_{th}$=-1.15V
μ=1.4x10$^{-3}$cm$^2$/Vs
S=550mV/dec
$I_D$(A)
-10μ
-8μ
-6μ
-4μ
-2μ
0
$I_G$(A)
8μ
4μ
0
-4μ
-8μ
-2.0
-1.5
-1.0
-0.5
0.0
$V_G$(V)


FIG. 4b

FIG. 5a

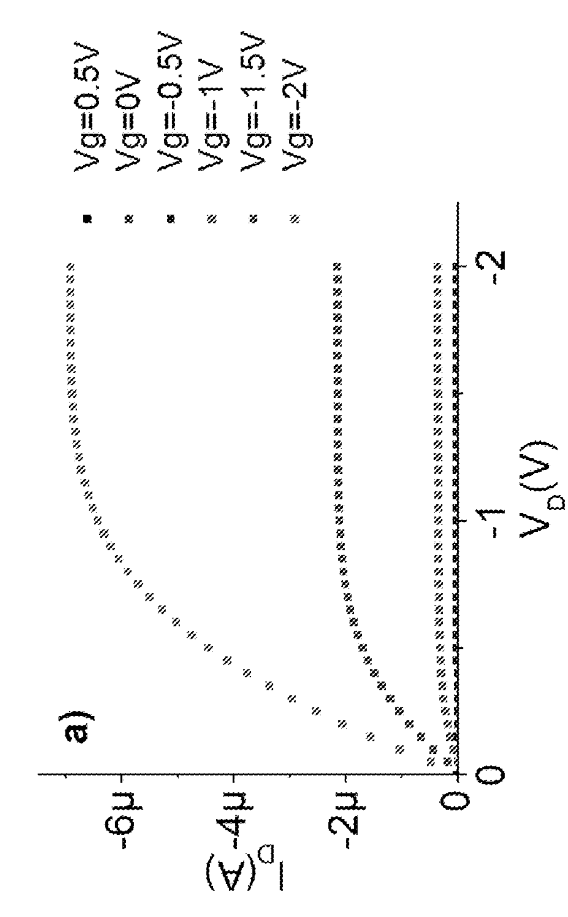


FIG. 5b

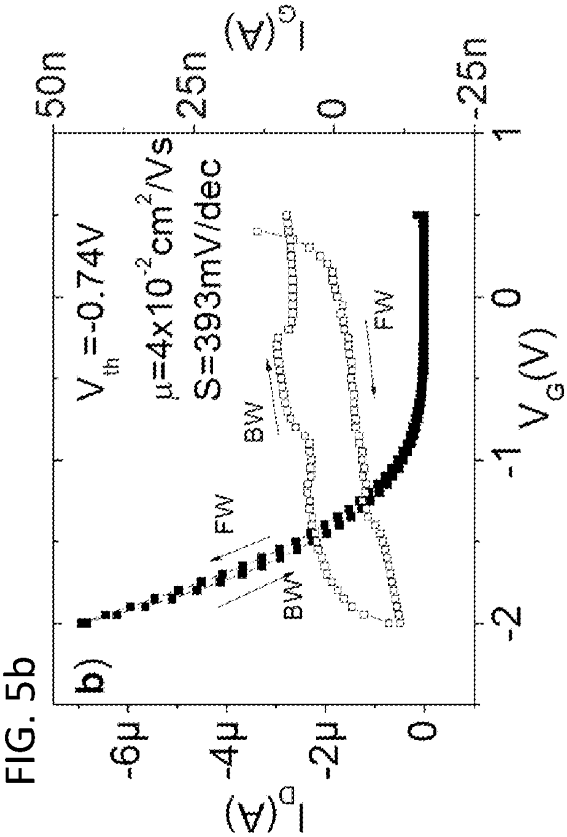


FIG. 5c

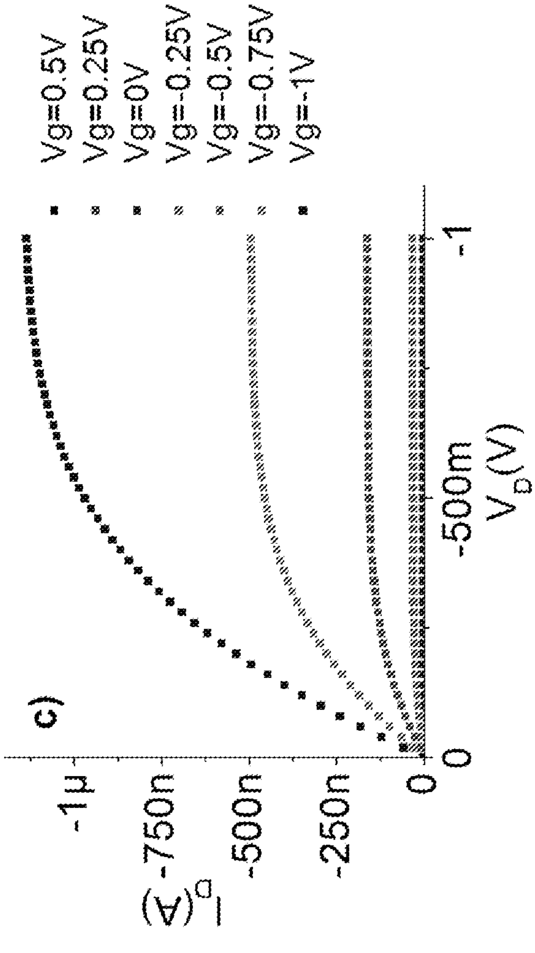


FIG. 5d

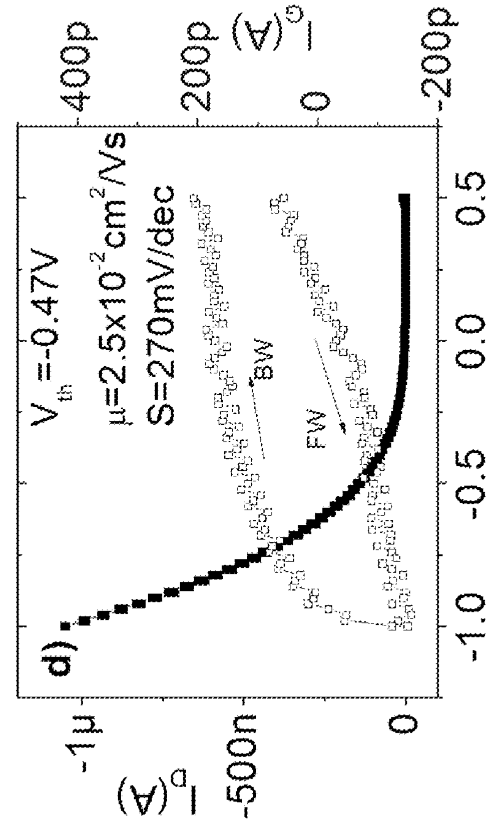

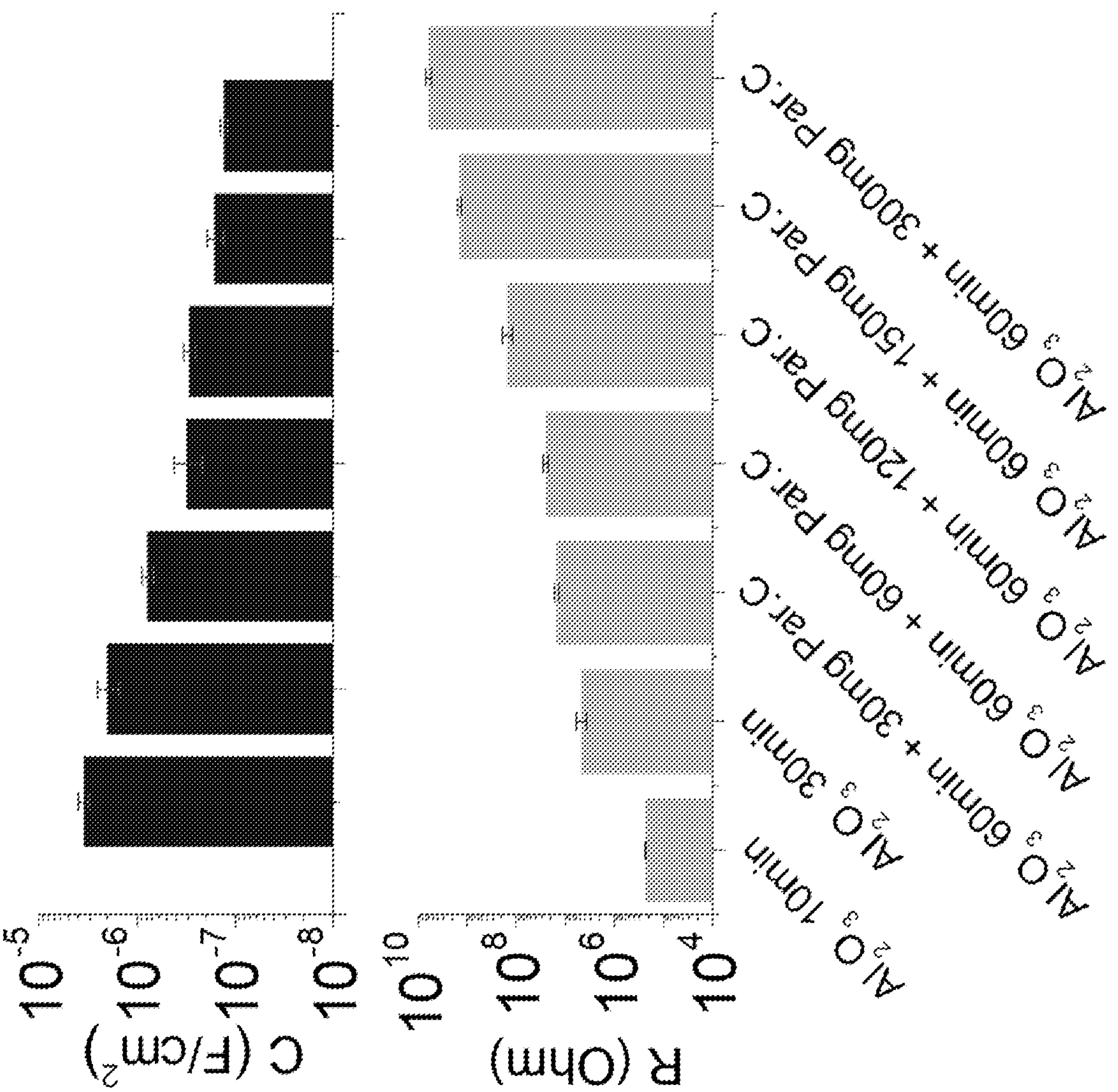
C (F/cm$^2$)
$10^{-5}$
$10^{-6}$
$10^{-7}$
$10^{-8}$
R (Ohm)
$10^{10}$
$10^{8}$
$10^{6}$
$10^{4}$
$Al_2O_3$ 10min
$Al_2O_3$ 30min
$Al_2O_3$ 60min + 30mg Par.C
$Al_2O_3$ 60min + 60mg Par.C
$Al_2O_3$ 60min + 120mg Par.C
$Al_2O_3$ 60min + 150mg Par.C
$Al_2O_3$ 60min + 300mg Par.C

FIG. 6

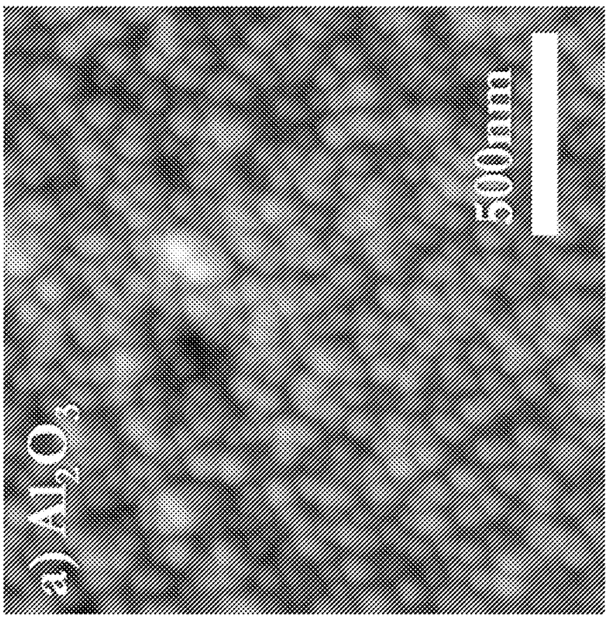

FIG. 7a

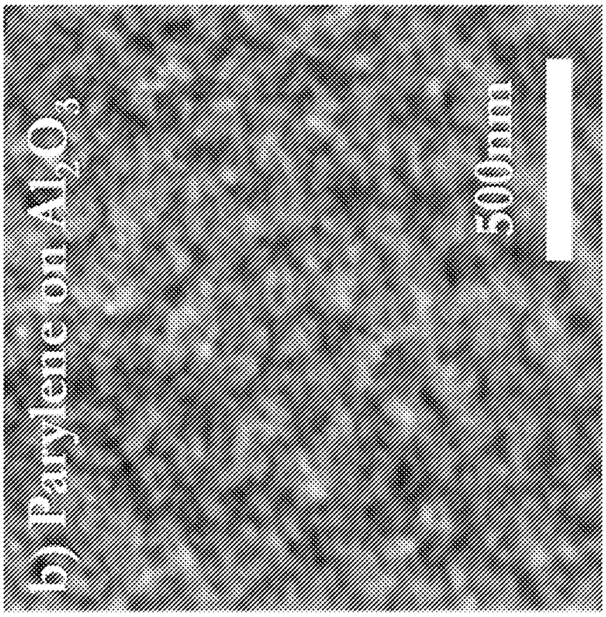

FIG. 7b

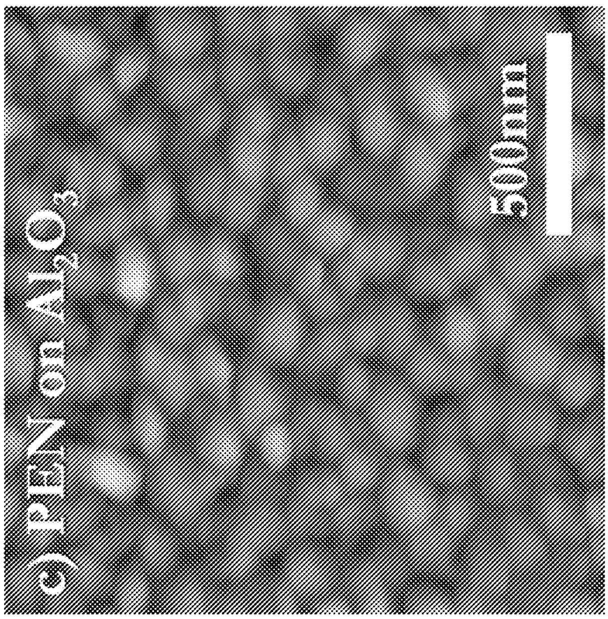

FIG. 7c

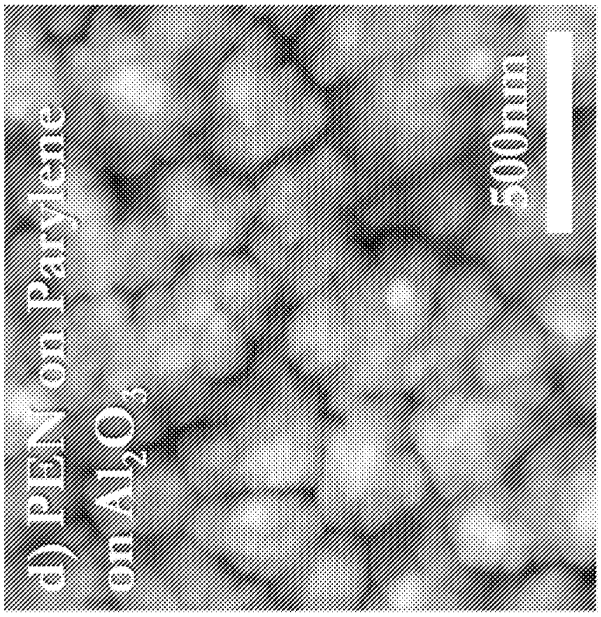

FIG. 7d

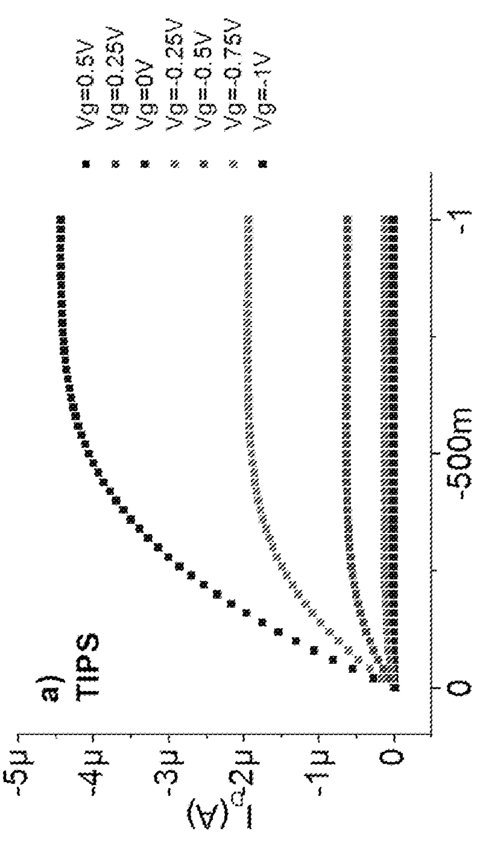


FIG. 8a

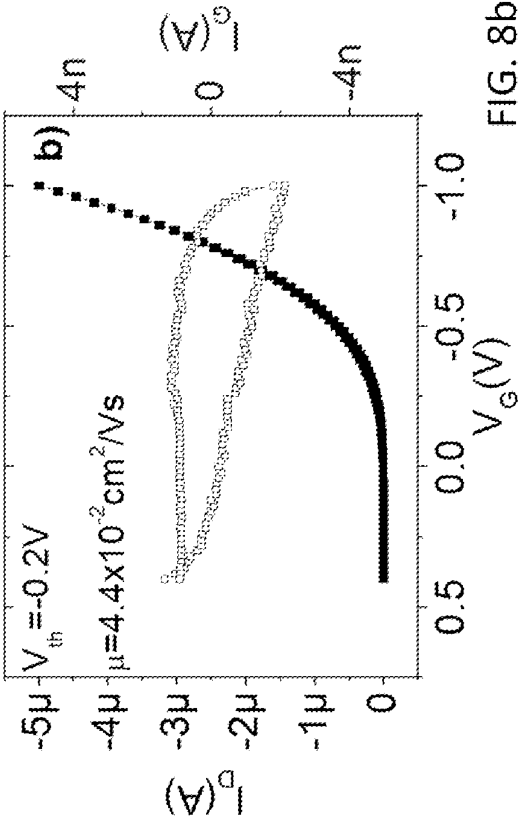


FIG. 8b

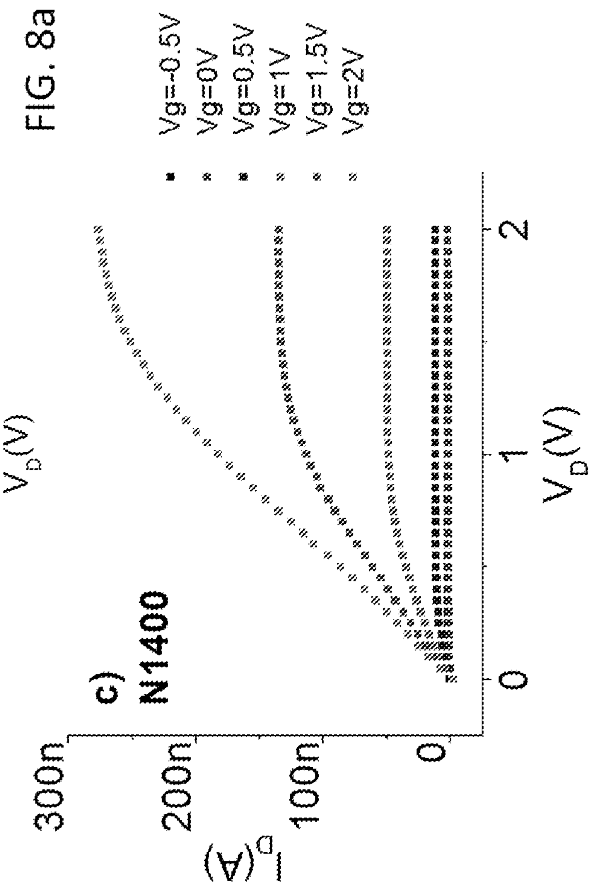


FIG. 8c

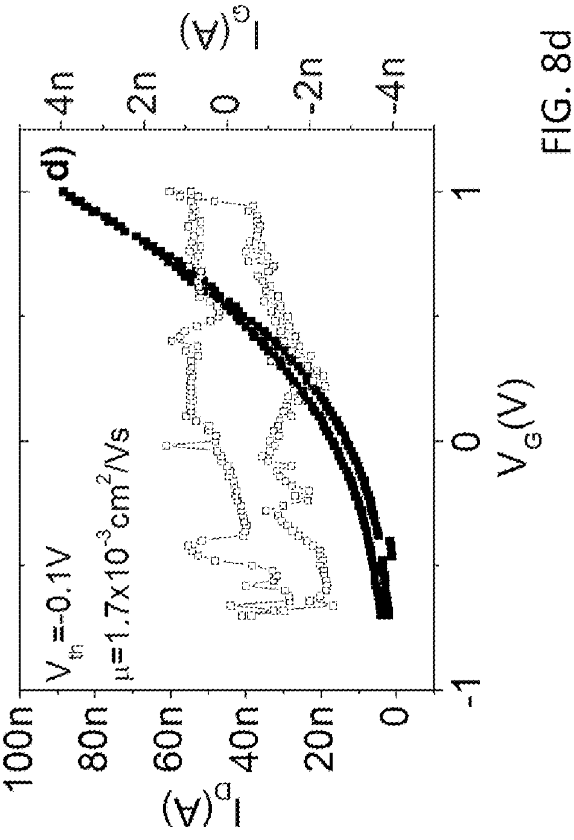


FIG. 8d

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20100135937 A
- US 7029945 B


### Non-patent literature cited in the description


- **TSUYOSHI SEKITANI et al.** Organic transistors manufactured using inkjet technology with subfemtoliter accuracy. *PNAS,* 01 April 2008, vol. 105 (13), 4977
- **WOO CHEOL SHIN et al.** Low-Voltage High-Performance Pentacene Thin-Film Transistors With Ultrathin PVP/High-κ HfLaO Hybrid Gate Dielectric. *IEEE ELECTRON DEVICE LETTERS,* November 2010, vol. 31 (11), 1308